# EUROPEAN PATENT SPECIFICATION

(11) **EP 4 034 605 B1**
(45) Date of publication and mention of the grant of the patent: **17.01.2024**
(21) Application number: 20867124.8
(22) Date of filing: 18.09.2020
(51) Int. Cl.: C09G 1/00, C09G 1/02, C23F 1/10, C23F 3/04, H01L 21/321

(54) **POLISHING COMPOSITIONS AND METHODS OF USE THEREOF**
POLIERZUSAMMENSETZUNGEN UND VERFAHREN ZU IHRER VERWENDUNG
COMPOSITIONS DE POLISSAGE ET LEURS PROCÉDÉS D'UTILISATION

(30) Priority: 24.09.2019 US 201962904857 P
(43) Date of publication of application: 03.08.2022
(73) Proprietor: FUJIFILM Electronic Materials U.S.A., Inc., N. Kingstown, RI 02852 (US)
(72) Inventor: LIANG, Yannan, Gilbert, Arizona 85234 (US); WEN, Liqing, Mesa, Arizona 85215 (US); HU, Bin, Chandler, Arizona 85248 (US); LIN, Tawei, Chandler, Arizona 85249 (US)
(74) Representative: Fish & Richardson P.C.
(86) International application number: PCT/US2020/051401
(87) International publication number: WO 2021/061510

(56) References cited:
- WO-A1-2017/025536
- WO-A1-2018/150856
- US-A1- 2003 228 763
- US-A1- 2016 186 029
- US-A1- 2016 189 976
- US-A1- 2018 002 571
- US-A1- 2018 340 094
- US-B1- 8 545 715

## Description

### CROSS-REFERENCE TO RELATED APPLICATION

The present application claims priority to U.S. Provisional Application Serial No. 62/904,857, filed on September 24, 2019.

### BACKGROUND

The semiconductor industry is continually driven to improve chip performance by further miniaturization of devices by process, materials, and integration innovations. Earlier materials innovations included the introduction of copper, replacing aluminum as the conductive material in the interconnect structure, and the use of tantalum (Ta)/tantalum nitride (TaN) as diffusion barrier to separate the Cu conductive material from the non-conductive/insulator dielectric material. Copper (Cu) was chosen as the interconnect material because of its low resistivity and superior resistance against electro-migration.

However, as the features of newer generation chips shrink, the multilayer Cu/barrier/dielectric stacks have to be thinner and more conformal to maintain effective interconnect resistivity in Back End of Line (BEOL). The thinner Cu and the Ta/TaN barrier film schemes present problems with resistivity and flexibility in deposition. For example, with smaller dimensions and advanced manufacturing nodes, resistivity is proceeding to be exponentially worse and improvements in transistor circuit speed (at Front End of Line (FEOL)) are being cut in half by the delay coming from the conductive Cu/Barrier wiring (BEOL). Cobalt (Co) has emerged as a leading candidate for use as a liner material, a barrier layer, as well as a conductive layer. Furthermore, cobalt is also being investigated as a replacement for tungsten (W) metal in multiple applications such as W metal contacts, plugs, vias, and gate materials.

Many currently available chemical mechanical polishing (CMP) slurries were specifically designed to remove materials more common in older chip designs, such as the aforementioned copper and tungsten. Certain components in these older CMP slurries may cause deleterious and unacceptable defects in cobalt, since cobalt is more susceptible to chemical corrosion. As a result, when using copper polishing slurries on cobalt layers, unacceptable corrosion, wafer topography, and removal rate selectivity often occur.

US 8 545 715 B1 describes chemical mechanical polishing compositions for semiconductor substrates. WO 2017/025536 A1 describes a use of chemical mechanical polishing compositions for polishing of cobalt comprising substrates.

With the increasing use of Cobalt (Co) as a metal component in semiconductor fabrication, there is a market need for CMP slurries that can effectively polish a dielectric component or a barrier component on Co-containing surfaces without significant Co corrosion.

### SUMMARY

The present invention is defined by the independent claims. The dependent claims depict additional embodiments of the invention.

As defined herein, unless otherwise noted, all percentages expressed should be understood to be percentages by weight to the total weight of the chemical mechanical polishing composition.

In one aspect, embodiments disclosed herein relate to a polishing composition that includes an abrasive; a pH adjuster; a barrier film removal rate enhancer; a first low-k removal rate inhibitor; a second low-k removal rate inhibitor different from the first low-k removal rate inhibitor; an azole-containing corrosion inhibitor; and a cobalt corrosion inhibitor.

In another aspect, embodiments disclosed herein relate to a method of polishing a substrate, including the steps of: applying the polishing composition described above to a surface of a substrate, wherein the surface comprises cobalt; and bringing a pad into contact with the surface of the substrate and moving the pad in relation to the substrate.

Other aspects and advantages of the claimed subject matter will be apparent from the following description and the appended claims.

### DETAILED DESCRIPTION

Embodiments disclosed herein relate generally to compositions and methods of using said compositions to polish substrates that include at least a cobalt portion and may, more specifically, include at least cobalt and copper portions. The compositions disclosed herein can effectively suppress low-k removal rate, minimize cobalt liner loss, and reduce defects observed on copper surfaces after polishing, while still effectively removing a barrier film (e.g., a Ta or TaN film). For example, the compositions disclosed herein can be particularly useful for polishing advanced node films that include copper, a cobalt liner, barrier (Ta, TaN) and dielectric materials (TEOS, low-k, ultra low-k, etc.)

With the introduction of cobalt (Co) as a barrier layer, conductive layer, and/or W replacement, there is a market need for CMP slurries that can polish Co at effective material removal rates without experiencing significant Co corrosion and have a range of selectivities in polishing rates of other metals and metal oxides (Cu, Ti, Ta₂O₅, TiO₂, RuO₂, etc.), and dielectric films (SiN, silicon oxide, Poly-Si, low k dielectrics (e.g., carbon doped silicon oxides), etc.). Because Co is more chemically reactive than Cu and other noble metals, Co corrosion prevention is very challenging in advanced nodes slurry design. Current metal polishing slurries are ill-equipped to polish surfaces that include Co as they suffer from Co corrosion issues during the CMP process. In addition, it is generally desirable to remove a certain amount of Co during polishing to form a smooth surface in a patterned semiconductor substrate for subsequent manufacturing processes. For example, during some fabrication processes there is often a significant amount of dishing in the copper and cobalt portions after removing the excess copper deposition. For this reason, during the subsequent barrier polishing step, the polishing composition of the present disclosure can be formulated to polish barrier materials (Ta or TaN) at a higher rate than it removes the cobalt from the liner and copper metal to correct the prior dishing so that the polished film may have a smooth topography. Thus, an objective of the polish composition in the present disclosure is to have a suitable Co removal rate while effectively removing certain target materials (such as Ta or TaN).

In one or more embodiments, the polishing composition includes an abrasive; a pH adjuster; a barrier film rate removal enhancer; a first low-k removal rate inhibitor; a second low-k removal rate inhibitor; an azole-containing corrosion inhibitor; and a cobalt corrosion inhibitor. In one or more embodiments, the polishing composition can also include a chelating agent. In one or more embodiments, a polishing composition according to the present disclosure can include from about 0.1% to about 50% by weight abrasive, about 0.05% to about 10% by weight pH adjuster, about 0.02% to about 4% by weight barrier film removal rate enhancer, about 0.005% to about 5% by weight first low-k removal rate inhibitor, about 0.005% to about 5% by weight a second low-k removal rate inhibitor, about 0.0001% to about 1% by weight azole-containing corrosion inhibitor, about 0.0001% to about 1% by weight cobalt corrosion inhibitor, and the remaining percent by weight (e.g., from about 20% to about 99% by weight) of solvent (e.g., deionized water). In one or more embodiments, the polishing composition can further include from about 0.001% to about 1% of chelating agent.

In one or more embodiments, the present disclosure provides a concentrated polishing composition that can be diluted with water prior to use by up to a factor of two, or up to a factor of four, or up to a factor of six, or up to a factor of eight, or up to a factor of ten. In other embodiments, the present disclosure provides a point-of-use (POU) polishing composition for use on cobalt substrates, comprising the above-described polishing composition, water, and optionally an oxidizer.

In one or more embodiments, a POU polishing composition can include from about 0.1% to about 12% by weight abrasive, about 0.05% to about 5% by weight pH adjuster, about 0.02% to about 2% by weight barrier film removal rate enhancer, about 0.005% to about 0.5% by weight first low-k removal rate inhibitor, about 0.005% to about 0.5% by weight a second low-k removal rate inhibitor, about 0.0001% to about 0.1% by weight azole-containing corrosion inhibitor, about 0.0001% to about 0.1% by weight cobalt corrosion inhibitor, optionally about 0.1% to about 5% by weight oxidizer, and about 80% to about 99% by weight of solvent (e.g., deionized water). In one or more embodiments, the POU polishing composition can further include 0.001% to 0.1% of chelating agent.

In one or more embodiments, a concentrated polishing composition can include from about 1% to about 50% by weight abrasive, about 0.5% to about 10% by weight pH adjuster, about 0.2% to about 4% by weight barrier film removal rate enhancer, about 0.05% to about 5% by weight first low-k removal rate inhibitor, about 0.05% to about 5% by weight a second low-k removal rate inhibitor, about 0.001% to about 1% by weight azole-containing corrosion inhibitor, about 0.001% to about 1% by weight cobalt corrosion inhibitor, and the remaining percent by weight (e.g., from about 20% to about 98.5% by weight) of solvent (e.g., deionized water). In one or more embodiments, the concentrated polishing composition can further include from about 0.01% to about 1% of chelating agent.

In one or more embodiments, the polishing composition described herein can include at least one (e.g., two or three) abrasive. In some embodiments, the at least one abrasive is selected from the group consisting of cationic abrasives, substantially neutral abrasives, and anionic abrasives. In one or more embodiments, the at least one abrasive is selected from the group consisting of alumina, silica, titania, ceria, zirconia, co-formed products thereof (i.e., co-formed products of alumina, silica, titania, ceria, or zirconia), coated abrasives, surface modified abrasives, and mixtures thereof. In some embodiments, the at least one abrasive does not include ceria. In some embodiments, the at least one abrasive is high-purity, and can have less than about 100 ppm of alcohol, less than about 100 ppm of ammonia, and less than about 100 parts per billion (ppb) of an alkali cation such as sodium cation. The abrasive can be present in an amount of from about 0.1% to about 12% (e.g., from about 0.5% to about 10%), based on the total weight of the POU polishing composition, or any subranges thereof.

In some embodiments, the at least one abrasive is in an amount of from at least about 0.1% (e.g., at least about 0.5%, at least about 1%, at least about 2%, at least about 4%, at least about 5%, at least about 10%, at least about 12%, at least about 15%, or at least about 20%) by weight to at most about 50% (e.g., at most about 45%, at most about 40%, at most about 35%, at most about 30%, at most about 25%, at most about 20%, at most about 15%, at most about 12%, at most about 10%, or at most about 5%) by weight of the polishing composition described herein.

In one or more embodiments, the polishing composition described herein can include at least one (e.g., two or three) pH adjustor. In some embodiments, the at least one pH adjustor is selected from the group consisting of ammonium hydroxide, sodium hydroxide, potassium hydroxide, cesium hydroxide, monoethanolamine, diethanolamine, triethanolamine, methylethanolamine, methyldiethanolamine tetrabutylammonium hydroxide, tetrapropylammonium hydroxide, tetraethylammonium hydroxide, tetramethylammonium hydroxide, ethyltrimethylammonium hydroxide, diethyldimethylammonium hydroxide, dimethyldipropylammonium hydroxide, benzyltrimethylammonium hydroxide, tris(2-hydroxyethyl)methylammonium hydroxide, choline hydroxide, and any combinations thereof.

In some embodiments, the at least one pH adjuster is in an amount of from at least about 0.05% (e.g., at least about 0.1%, at least about 0.2%, at least about 0.4%, at least about 0.5%, at least about 0.8%, at least about 1%, at least about 2%, at least about 5%, or at least about 7%) by weight to at most about 10% (e.g., at most about 9%, at most about 8%, at most about 7%, at most about 6%, at most about 5%, at most about 4%, at most about 3%, at most about 2%, at most about 1%, at most about 0.5%, at most about 0.2%, or at most about 0.1%) by weight of the polishing composition described herein.

In some embodiments, the pH value of the polishing composition can range from at least about 7 (e.g., at least about 7.5, at least about 8, at least about 8.5, at least about 9, at least about 9.5, at least about 10, at least about 10.5, at least about 11, at least about 11.5, or at least about 12) to at most about 14 (e.g., at most about 13.5, at most about 13, at most about 12.5, at most about 12, at most about 11.5, at most about 11, at least about 10.5, at most about 10, at most about 9.5, or at most about 9). Without wishing to be bound by theory, it is believed that a polishing composition having a pH lower than 7 would significantly increase cobalt removal rate and corrosion, and a polishing composition having a pH higher than 14 can affect the stability of the suspended abrasive and would significantly increase the roughness and decrease the overall quality of a film polished by such a composition. In order to obtain the desired pH, the relative concentrations of the ingredients in the polishing compositions described herein can be adjusted.

In one or more embodiments, the polishing composition described herein can include at least one (e.g., two or three) barrier film removal rate enhancer. In some embodiments, the at least one barrier film removal rate enhancer is an organic acid (such as a carboxylic acid, an amino acid, a sulfonic acid, or a phosphonic acid) or a salt thereof. In some embodiments, the barrier film removal rate enhancer can be an organic acid or a salt thereof selected from the group consisting of gluconic acid, lactic acid, citric acid, tartaric acid, malic acid, glycolic acid, malonic acid, formic acid, oxalic acid, acetic acid, propionic acid, peracetic acid, succinic acid, lactic acid, amino acetic acid, phenoxyacetic acid, bicine, diglycolic acid, glyceric acid, tricine, alanine, histidine, valine, phenylalanine, proline, glutamine, aspartic acid, glutamic acid, arginine, lysine, tyrosine, benzoic acid, 1,2-ethanedisulfonic acid, 4-amino-3-hydroxy-1-naphthalenesulfonic acid, 8-hydroxyquinoline-5-sulfonic acid, aminomethanesulfonic acid, benzenesulfonic acid, hydroxylamine O-sulfonic acid, methanesulfonic acid, m-xylene-4-sulfonic acid, poly(4-styrenesulfonic acid), polyanetholesulfonic acid, p-toluenesulfonic acid, trifluoromethane-sulfonic acid, ethyl phosphoric acid, cyanoethyl phosphoric acid, phenyl phosphoric acid, vinyl phosphoric acid, poly(vinylphosphonic acid), 1-hydroxyethane-1,1-diphosphonic acid, nitrilotri(methylphosphonic acid), diethylenetriaminepentakis (methylphosphonic acid), N,N,N'N'-ethylenediaminetetrakis(methylene phosphonic acid), n-hexylphosphonic acid, benzylphosphonic acid, phenylphosphonic acid, salts thereof, and mixtures thereof. Without wishing to be bound by theory, it is surprising that an organic acid or a salt thereof (such as those described above) can be used as an effective barrier removal rate enhancer in the polishing composition described herein to improve the removal rate of a barrier film (e.g., a Ta or TaN film) in a semiconductor substrate.

In some embodiments, the barrier film rate removal rate enhancer is in an amount of from at least about 0.02% (e.g., at least about 0.05%, at least about 0.1%, at least about 0.2%, at least about 0.4%, at least about 0.5%, at least about 0.6%, at least about 0.8%, at least about 1%, at least about 1.5%, or at least about 2%) by weight to at most about 4% (e.g., at most about 3.5%, at most about 3%, at most about 2.5%, at most about 2%, at most about 1.5%, or at most about 1%) by weight of the polishing composition described herein.

In one or more embodiments, the polishing composition described herein can include at least one (e.g., two or three) first low-k removal rate inhibitor. In some embodiments, the at least one first low-k removal rate inhibitor is a nonionic surfactant. In one or more embodiments, the nonionic surfactant is selected from the group consisting of alcohol alkoxylates, alkylphenol alkoxylates, tristyrylphenol alkoxylates, sorbitan ester alkoxylates, polyalkoxylates, polyalkylene oxide block copolymers, tetrahydroxy oligomers, alkoxylated diamines, and mixtures thereof. In one or more embodiments, the nonionic surfactant is a polymer having a number average molecular weight of at least about 1,000 g/mol, or at least about 2,500 g/mol, or at least about 5,000 g/mol, or at least about 7,500 g/mol, or at least about 10,000 g/mol. In one or more embodiments, the nonionic surfactant is a polymer having a number average molecular weight of at most about 1,000,000 g/mol, or at most about 750,000 g/mol, or at most about 500,000 g/mol, or at most about 250,000 g/mol, or at most about 100,000 g/mol. In one or more embodiments, the alkoxylate groups of the alkoxylated nonionic surfactants are ethoxylate, propoxylate, or a combination of ethoxylate and propoxylate groups. Without wishing to be bound by theory, it is surprising that a nonionic surfactant (such as those described above) can be used as a low-k removal rate inhibitor in the polishing composition described herein to reduce or minimize the removal rate of a low-k film (e.g., a carbon doped silicon oxide film) in a semiconductor substrate.

In some embodiments, the first low-k removal rate inhibitor is in an amount of from at least about 0.005% (e.g., at least about 0.01%, at least about 0.05%, at least about 0.1%, at least about 0.5%, at least about 1%, at least about 1.5%, at least about 2%, or at least about 3%) by weight to at most about 5% (e.g., at most about 4.5%, at most about 4%, at most about 3.5%, at most about 3%, at most about 2.5%, at most about 2%, at most about 1.5%, at most about 1%, at most about 0.5%, or at most about 0.1%) by weight of the polishing composition described herein.

In one or more embodiments, the polishing composition described herein can include at least one (e.g., two or three) second low-k removal rate inhibitor. In some embodiments, the at least one second low-k removal rate inhibitor is an amphiphilic copolymer. In one or more embodiments, the amphiphilic copolymer is a styrene maleic anhydride copolymer. In one or more embodiments, the amphiphilic copolymer has a number average molecular weight of from at least about 1,000 g/mol (e.g., at least about 2,500 g/mol, at least about 5,000 g/mol, at least about 7,500 g/mol, at least about 10,000 g/mol) to at most about 200,000 g/mol (e.g., at most about 150,000 g/mol, at most about 100,000 g/mol, at most about 50,000 g/mol, or at most about 25,000 g/mol). Without wishing to be bound by theory, it is surprising that an amphiphilic copolymer (such as those described above) can be used as a low k removal rate inhibitor in the polishing composition described herein to reduce or minimize the removal rate of a low-k film (e.g., a carbon doped silicon oxide film) in a semiconductor substrate.

In some embodiments, the second low-k removal rate inhibitor is in an amount of from at least about 0.005% (e.g., at least about 0.01%, at least about 0.05%, at least about 0.1%, at least about 0.5%, at least about 1%, at least about 1.5%, at least about 2%, or at least about 3%) by weight to at most about 5% (e.g., at most about 4.5%, at most about 4%, at most about 3.5%, at most about 3%, at most about 2.5%, at most about 2%, at most about 1.5%, at most about 1%, at most about 0.5%, or at most about 0.1%) by weight of the polishing composition described herein.

Without wishing to be bound by theory, it is found surprisingly that including both a nonionic surfactant (i.e., the first low-k removal rate inhibitor) and an amphiphilic copolymer (i.e., the second low-k removal rate inhibitor) in the polishing composition described herein can result in a synergistic effect and can reduce the removal rate of a low-k film (e.g., a carbon doped silicon oxide film) much more than the addition of the removal rate reduction of each component when used individually.

In one or more embodiments, the polishing composition described herein can include at least one (e.g., two or three) azole-containing corrosion inhibitor. In some embodiments, the at least one azole-containing corrosion inhibitor is selected from the group consisting of substituted or unsubstituted triazoles, substituted or unsubstituted tetrazoles, substituted or unsubstituted benzotriazoles, substituted or unsubstituted pyrazoles, and substituted or unsubstituted imidazoles. In one or more embodiments, the azole-containing corrosion inhibitor can be selected from the group consisting of triazole, 1,2,4-triazole, tetrazole, benzotriazole, tolyltriazole, ethyl benzotriazole, propyl benzotriazole, butyl benzotriazole, pentyl benzotriazole, hexyl benzotriazole, dimethyl benzotriazole, chloro benzotriazole, dichloro benzotriazole, chloromethyl benzotriazole, chloroethyl benzotriazole, phenyl benzotriazole, benzyl benzotriazole, aminotriazole, aminobenzimidazole, aminotetrazole, and mixtures thereof. Without wishing to be bound by theory, it is believed that an azole-containing corrosion inhibitor (such as those described above) can significantly reduce or minimize the removal rate of copper in a semiconductor substrate.

In some embodiments, the azole-containing corrosion inhibitor is in an amount of from at least about 0.0001% (e.g., at least about 0.0002%, at least about 0.0005%, at least about 0.001%, at least about 0.002%, at least about 0.005%, at least about 0.01%, at least about 0.02%, at least about 0.05%, at least about 0.1%, at least about 0.2%, or at least about 0.5%) by weight to at most about 1% (e.g., at most about 0.8%, at most about 0.6%, at most about 0.5%, at most about 0.4%, at most about 0.2%, at most about 0.1%, at most about 0.05%, at most about 0.02%, at most about 0.01%, or at most about 0.005%) by weight of the polishing composition described herein.

In one or more embodiments, the polishing composition described herein can include at least one (e.g., two or three) cobalt corrosion inhibitor. In some embodiments, the at least one cobalt corrosion inhibitor is an anionic surfactant. In one or more embodiments, the anionic surfactant comprises one or more phosphate groups and one or more of the following groups: a six to twenty four carbon alkyl chain, from zero to eighteen ethylene oxide groups, or a combination thereof. In one or more embodiments, the alkyl chain can have at least eight carbons, at least ten carbons, at least twelve carbons, or at least fourteen carbons. In one or more embodiments, the alkyl chain can have at most 22 carbons, or at most 20 carbons, or at most 18 carbons. Without wishing to be bound by theory, it is surprising that an anionic surfactant (such as those described above) can be used as a cobalt corrosion inhibitor in the polishing composition described herein to reduce or minimize the removal rate of cobalt in a semiconductor substrate.

In some embodiments, the cobalt corrosion inhibitor is in an amount of from at least about 0.0001% (e.g., at least about 0.0002%, at least about 0.0005%, at least about 0.001%, at least about 0.002%, at least about 0.005%, at least about 0.01%, at least about 0.02%, at least about 0.05%, at least about 0.1%, at least about 0.2%, or at least about 0.5%) by weight to at most about 1% (e.g., at most about 0.8%, at most about 0.6%, at most about 0.5%, at most about 0.4%, at most about 0.2%, at most about 0.1%, at most about 0.05%, at most about 0.02%, at most about 0.01%, or at most about 0.005%) by weight of the polishing composition described herein.

In one or more embodiments, the polishing composition described herein can include at least one (e.g., two or three) optional chelating agent. In some embodiments, the at least one optional chelating agent can be an amino-containing carboxylic acid (e.g., a polyaminopolycarboxylic acid) or a phosphonic acid. In some embodiments, the chelating agent is selected from the group consisting of ethylenediaminetetracetic acid, iminodiacetic acid, N-hydroxyethyl-ethylenediaminetriacetic acid, nitrilotriacetic acid, diethylenetriaminepentacetic acid, hydroxyethylethylenediaminetriacetic acid, triethylenetetraaminehexaacetic acid, diaminocycloheanetetraacetic acid, nitrilotrimethylphosphonic acid, ethylenediaminetetra(methylenephosphonic acid), 1-hydroxyl ethylidene-1,1,-diphosphonic acid, diethylenetriamine penta (methylene phosphonic acid), and combinations thereof. Without wishing to be bound by theory, it is believed that including a chelating agent (such as those described above) in the polishing composition described herein can significantly reduce or minimize the observed defects on a semiconductor substrate (such as a copper wafer).

In some embodiments, the chelating agent is in an amount of from at least about 0.001% (e.g., at least about 0.002%, at least about 0.005%, at least about 0.01%, at least about 0.02%, at least about 0.05%, at least about 0.1%, at least about 0.2%, or at least about 0.5%) by weight to at most about 1% (e.g., at most about 0.8%, at most about 0.6%, at most about 0.5%, at most about 0.4%, at most about 0.2%, at most about 0.1%, at most about 0.05%, at most about 0.02%, at most about 0.01%, or at most about 0.005%) by weight of the polishing composition described herein.

An optional oxidizer can be added when diluting a concentrated slurry to form a POU slurry. The oxidizer can be selected from the group consisting of hydrogen peroxide, ammonium persulfate, silver nitrate (AgNOs), ferric nitrates or chlorides, per acids or salts, ozone water, potassium ferricyanide, potassium dichromate, potassium iodate, potassium bromate, potassium periodate, periodic acid, vanadium trioxide, hypochlorous acid, sodium hypochlorite, potassium hypochlorite, calcium hypochlorite, magnesium hypochlorite, ferric nitrate, potassium permanganate, other inorganic or organic peroxides, and mixtures thereof. In one embodiment, the oxidizer is hydrogen peroxide.

In some embodiments, the oxidizer is in an amount of from at least about 0.05% (e.g., at least about 0.1%, at least about 0.2%, at least about 0.4%, at least about 0.5%, at least about 1%, at least about 1.5%, at least about 2%, at least about 2.5%, at least about 3%, at least about 3.5%, at least about 4%, or at least about 4.5%) by weight to at most about 5% (e.g., at most about 4.5%, at most about 4%, at most about 3.5%, at most about 3%, at most about 2.5%, at most about 2%, at most about 1.5%, at most about 1%, at most about 0.5%, or at most about 0.1%) by weight of the polishing composition described herein. In some embodiments, without wishing to be bound by theory, it is believed that the oxidizer can help remove metal films by forming a metal complex with the chelating agent so that the metal can be removed during the CMP process. In some embodiments, without wishing to be bound by theory, it is believed that the metal complex formed between a metal film and an oxidizer can form a passivation layer, which can protect the metal from corrosion. In some embodiments, the oxidizer may reduce the shelf life of a polishing composition. In such embodiments, the oxidizer can be added to the polish composition at the point of use right before polishing.

In some embodiments, the polishing composition described herein can include a solvent (e.g., a primary solvent), such as water. In some embodiments, the solvent (e.g., water) is in an amount of from at least about 20% (e.g., at least about 25%, at least about 30%, at least about 35%, at least about 40%, at least about 45%, at least about 50%, at least about 55%, at least about 60%, at least about 65%, at least about 70%, at least about 75%, at least about 80%, at least about 85%, at least about 90%, at least about 92%, at least about 94%, at least about 95%, or at least about 97%) by weight to at most about 99% (e.g., at most about 98%, at most about 96%, at most about 94%, at most about 92%, at most about 90%, at most about 85%, at most about 80%, at most about 75%, at most about 70%, or at most about 65%) by weight of the polishing composition described herein.

In one or more embodiments, an optional secondary solvent (e.g., an organic solvent) can be used in the polish composition (e.g., the POU or concentrated polishing composition) of the present disclosure, which can help with the dissolution of the azole-containing corrosion inhibitor. In one or more embodiments, the secondary solvent can be one or more alcohols, alkylene glycols, or alkylene glycol ethers. In one or more embodiments, the secondary solvent comprises one or more solvents selected from the group consisting of ethanol, 1-propanol, 2-propanol, n-butanol, propylene glycol, 2-methoxyethanol, 2-ethoxyethanol, propylene glycol propyl ether, and ethylene glycol.

In some embodiments, the secondary solvent is in an amount of from at least about 0.0025% (e.g., at least about 0.005%, at least about 0.01%, at least about 0.02%, at least about 0.05%, at least about 0.1%, at least about 0.2%, at least about 0.4%, at least about 0.6%, at least about 0.8%, or at least about 1%) by weight to at most about 2% (e.g., at most about 1.8%, at most about 1.6%, at most about 1.5%, at most about 1.4%, at most about 1.2%, at most about 1%, at most about 0.8%, at most about 0.6%, at most about 0.5%, or at most about 0.1%) by weight of the polishing composition described herein.

In one or more embodiments, the polishing composition described herein can be substantially free of one or more of certain ingredients, such as organic solvents, pH adjusting agents, quaternary ammonium compounds (e.g., salts or hydroxides), amines, alkali bases (such as alkali hydroxides), fluoride containing compounds, silanes (e.g., alkoxysilanes), imines (e.g., amidines such as 1,8-diazabicyclo[5.4.0]-7-undecene (DBU) and 1,5-diazabicyclo[4.3.0]non-5-ene (DBN)), salts (e.g., halide salts or metal salts), polymers (e.g., cationic or anionic polymers), surfactants (e.g., cationic surfactants, anionic surfactants, or non-ionic surfactants), plasticizers, oxidizing agents (e.g., H₂O₂), corrosion inhibitors (e.g., azole or non-azole corrosion inhibitors), and/or certain abrasives (e.g., ceria abrasives, non-ionic abrasives, surface modified abrasives , or negatively/positively charged abrasive). The halide salts that can be excluded from the polishing compositions include alkali metal halides (e.g., sodium halides or potassium halides) or ammonium halides (e.g., ammonium chloride), and can be chlorides, bromides, or iodides. As used herein, an ingredient that is "substantially free" from a polishing composition refers to an ingredient that is not intentionally added into the polishing composition. In some embodiments, the polishing composition described herein can have at most about 1000 ppm (e.g., at most about 500 ppm, at most about 250 ppm, at most about 100 ppm, at most about 50 ppm, at most about 10 ppm, or at most about 1 ppm) of one or more of the above ingredients that are substantially free from the polishing composition. In some embodiments, the polishing composition described herein can be completely free of one or more of the above ingredients.

In one or more embodiments, the polishing composition described herein can have a ratio of a removal rate for silicon oxides (e.g., TEOS), barrier materials (e.g., Ta, TaN) to a removal rate for Cu, Co, or a low-k dielectric material (i.e., a removal rate selectivity) of from at least about 3:1 (e.g., at least about 4:1, at least about 5:1, at least about 10:1, at least about 25:1, at least about 50:1, at least about 60:1, at least about 75:1, at least about 100:1, at least about 150:1, at least about 200:1, at least about 250:1, or at least about 300:1) to at most about 1000:1 (e.g., at most about 500:1). In one or more embodiments, the ratios described above can be applicable when measuring removal rates for polishing either blanket wafers or patterned wafers (e.g., wafers including conductive layers, barrier layers, and/or dielectric layers).

In one or more embodiments, the total defect counts on a wafer (e.g., on a copper surface of a wafer) having a diameter of 12 inches (i.e., about 300 mm) is at most 800 (e.g., at most 700, at most 600, at most 500, at most 400, at most 300, at most 250, at most 200, at most 150, at most 100, or at most 50) when polishing the wafer using a polishing composition according to the present disclosure. In one or more embodiments, the defects may result from scratches, organic residue, particle contamination (e.g., abrasive), and combinations thereof. In general, the defects may be counted by using a laser scattering inspection system and then analyzed and classified by reviewing images of the polished wafer taken using a scanning electron microscope (SEM). In one or more embodiments, the defects counted are those at least about 100 nm in size.

The present disclosure also contemplates a method of using any of the above-described polishing compositions (e.g., concentrates or POU slurries). With the concentrate, the method can comprise the steps of diluting the concentrate to form the POU slurry (e.g., by a factor of at least two), and then contacting a surface at least partially comprising cobalt with the POU slurry. In some embodiment, an oxidizer can be added to the slurry before or after the dilution. With the POU slurry, the method comprises the step of contacting the surface at least partially comprising cobalt with the slurry.

In one or more embodiments, this disclosure features a polishing method that can include applying a polishing composition according to the present disclosure to a substrate (e.g., a wafer) having at least cobalt on a surface of the substrate; and bringing a pad into contact with the surface of the substrate and moving the pad in relation to the substrate. In some embodiments, when the substrate includes at least one or more of silicon oxides and/or barrier materials (e.g., Ta, TaN), the above method can remove at least a portion of these materials without significantly removing cobalt. It is to be noted that the term "silicon oxide" described herein is expressly intended to include both un-doped and doped versions of silicon oxide. For example, in one or more embodiments, the silicon oxide can be doped with at least one dopant selected from carbon, nitrogen, oxygen, hydrogen, or any other known dopants for silicon oxide. Some examples of silicon oxide film types include TEOS (tetra-ethyl orthosilicate), SiOC, SiOCN, SiOCH, SiOH and SiON.

In some embodiments, the method that uses a polishing composition described herein can further include producing a semiconductor device from the substrate treated by the polishing composition through one or more steps. For example, photolithography, ion implantation, dry/wet etching, plasma ashing, deposition (e.g., PVD, CVD, ALD, ECD), wafer mounting, die cutting, packaging, and testing can be used to produce a semiconductor device from the substrate treated by the polishing composition described herein.

The specific examples below are to be construed as merely illustrative, and not limitative of the remainder of the disclosure in any way whatsoever. Without further elaboration, it is believed that one skilled in the art can, based on the description herein, utilize the present invention to its fullest extent.

### EXAMPLES

In these examples, the polishing was performed on 200 mm wafers, using an AMAT Mirra CMP polisher, a Fujibo H804 pad, a downforce pressure of 1.5 psi, a platen head velocity of 120/114 rpm, and a slurry flow rate of 175 mL/min.

The general compositions used in the examples below are shown in Table 1 below. The specifics details on the differences in the compositions tested will be explained in further detail when discussing the respective examples.

**Table 1**

| **Component** | **% By Weight of Composition** |
|---|---|
| pH adjuster (base) | 0.05-5 |
| Barrier Film Removal Rate Enhancer (Organic Acid) | 0.02-2 |
| Low-k Removal Rate Inhibitor | 0.01-1 |
| Azole-Containing Corrosion Inhibitor | 0.0001-0.1 |
| Cobalt Corrosion Inhibitor (anionic surfactant) | 0.0001-0.1 (if used) |
| Chelating Agent | 0.0001-0.1 (if used) |
| Abrasive (silica) | 0.1-12 |
| Oxidizer | 0.1-5 |
| Solvent (DI Water) | 80-99 |
| pH | 7-12 |

### Example 1

Table 2 below shows the removal rate for TEOS, Ta, Black Diamond 1 (BD-1), and Black Diamond 2 (BD-2) blanket wafers when polished using Composition 1-6. Compositions 1-6 contained the same ingredients at the same concentrations except for the differences identified below and in Table 2. Composition 1 included a single polyalkoxylate low-k removal rate inhibitor (LK RRI; a non-ionic surfactant) and served as a control. Each of Compositions 2-6 included a combination of two distinct LK RRI's (i.e., an alkoxylated diamine non-ionic surfactant (LK RRI-1) and an amphiphilic copolymer (LK RRI-2)) at several concentrations, as shown in Table 2. BD-1 and BD-2 blanket wafers are low-k dielectric materials (i.e., carbon doped silicon oxides) coated on silicon wafers.

The results showed surprisingly that a nonionic surfactant and an amphiphilic copolymer could be used as low-k removal rate inhibitors, and that the combination of these two inhibitors (i.e., LK RRI-1 and LK RRI-2) suppressed the polishing rates more effectively than the Comparative LK RRI. Further, the data show that as the concentration of LK RRI-1 in the combination of LK RRI-1 and LK RRI-2 increased, the removal rates of the low-k dielectric materials in BD-1 and BD-2 blanket wafers decreased much more significantly than the removal rates of TEOS and Ta, indicating their effect on the low-k removal rate.

**Table 2**

| | **Comp. 1 Control 1× LK RRI** | **Comp. 2 1×(LK RRI-1** + **LK RRI-2)** | **Comp. 3 3×(LK RRI-1** + **LK RRI-2)** | **Comp. 4 5×(LK RRI-1** + **LK RRI-2)** | **Comp. 5** 10**×**(LK RRI-1 + **LK RRI-2)** | **Comp. 6** 30**×**(LK **RRI-1** + **LK RRI-2)** |
|---|---|---|---|---|---|---|
| **TEOS RR (Å/min)** | 223 | 197 | 197 | 185 | 186 | 157 |
| **Ta RR (Å/min)** | 217 | 213 | 222 | 204 | 208 | 215 |
| **BD-1 RR (Å/min)** | 90 | 42 | 16 | 6 | 5 | 3 |
| **BD-2 RR (Å/min)** | 496 | 178 | 106 | 69 | 39 | 11 |

| | | | | | | |
|---|---|---|---|---|---|---|
| RR = removal rate | | | | | | |

### Example 2

Table 3 below shows the removal rate for Cu, TEOS, Ta, and BD-1 blanket wafers when polished using Polishing Compositions 7-14. Compositions 7-14 contained the same ingredients at the same concentrations except for the differences identified below and in Table 3. Composition 7 used the LK RRI and benzotriazole as the copper corrosion inhibitor (CI-1), and served as a control. Compositions 8-14 included the combination of the two distinct LK RRIs (LK RRI-1 and LK RRI-2) and a copper corrosion inhibitor selected from CI-1 (benzotriazole) and CI-3 to CI-5 (substituted benzotriazoles). Further, Compositions 8-14 also varied the concentration of the corrosion inhibitor from 6X to 25X as shown in Table 3.

The combination of the two distinct LK RRIs (LK RRI-1 and LK RRI-2) and a copper corrosion inhibitor selected from CI-1 and CI-3 to CI-5 showed comparable TEOS and Ta polishing rates to those achieved by Composition 7 and superior Cu removal rate inhibition performance (see Compositions 8-14). In other words, the results showed that the low-k removal rate inhibitors and the copper corrosion inhibitors did not substantially impact the removal rates of TEOS and Ta. On the other hand, the results showed that including a substituted benzotriazole could significantly reduce the copper removal rates (see Compositions 10-14).

**Table 3**

| | **CuRR (Å/min)** | **TEOS RR (Å/min)** | **Ta RR (Å/min)** | **BD-1 RR (Å/min)** |
|---|---|---|---|---|
| **Comp. 7 Control LK RRI 1×Cl-1** | 124 | 238 | 307 | 218 |
| **Comp. 8 5×(LK RRI-1+LK RRI-2) 6×Cl-1** | 127 | 196 | 275 | 11 |
| **Comp. 9 5×(LK RRI-1+LK RRI-2) 12×Cl-1** | 21 | 184 | 275 | 11 |
| **Comp. 10 5×(LK RRI-1+LK RRI-2) 10×Cl-3** | 9 | 199 | 312 | 7 |
| **Comp. 11 5×(LK RRI-1+LK RRI-2) 25×Cl-3** | 5 | 224 | 316 | 8 |
| **Comp. 12 5×(LK RRI-1+LK RRI-2) 6**×**Cl-4** | 7 | 201 | 271 | 10 |
| **Comp. 13 5×(LK RRI-1+LK RRI-2) 10×Cl-4** | 0 | 193 | 247 | 8 |
| **Comp. 14 5×(LK RRI-1+LK RRI-2) 10×Cl-5** | 0 | 176 | 220 | 7 |

### Example 3

Table 4 below shows the removal rate for Cu, Co, and BD blanket wafers and also the defect counts on the Cu wafer when polished using Polishing Compositions 15-21. Compositions 15-21 contained the same ingredients at the same concentrations except for the differences identified below and in Table 4. Composition 15 included the combination of two distinct LK RRIs (LK RRI 1 and LK RRI 2) and benzotriazole as a copper corrosion inhibitor (CI-1). Composition 16 was compositionally the same as Composition 15, but the copper corrosion inhibitor used was the alkylbenzotriazole (CI-5) instead of benzotriazole (CI-1). This change resulted in significantly fewer defects observed on the Cu wafer.

Composition 17 included a phosphate based anionic surfactant as a cobalt corrosion inhibitor (Co-CI) in addition to the copper corrosion inhibitor (CI-5). This addition significantly reduced the cobalt polishing rate and surprisingly also significantly reduced the defects observed on the Cu wafer even though the amount of CI-5 used was half of what was used in Composition 16.

Compositions 18-21 demonstrated surprisingly that adding a chelating agent (CA) can reduce the cobalt removal rates and the observed defects on a copper wafer. In particular, the use of a high concentration of the aminopolycarboxylic acid based chelating agent CA-1 in Composition 19 resulted in extremely low cobalt removal rates and superior reduction in defects on a copper wafer. Compositions 20 and 21 were analogous to Compositions 18 and 19 but used a different, and comparative, chelating agent (CA-2). CA-2 is a sulfonic acid based chelating agent and did not show the same ability to reduce the defects on the Cu wafer at a high concentration when compared with CA-1 used in Composition 19.

**Table 4**

| | **CuRR (Å/min)** | **CoRR (Å/min)** | **BDRR (Å/min)** | **Defects on Cu** |
|---|---|---|---|---|
| **Comp. 15 5.8×Cl-1** | 29 | 19 | 15 | 939 |
| **Comp. 16 0×CI-1 1×Cl-5** | 2 | 11 | 14 | 546 |
| **Comp. 17 0×CI-1 0.5×Cl-5 0.5**×**Co CI** | 22 | 2 | 15 | 232 |
| **Comp. 18 4.6×CI-1 1×CA-1** | 12 | 17 | 16 | 797 |
| **Comp. 19 4.6×CI-1 4×CA-1** | 11 | 3 | 14 | 85 |
| **Comp. 20 4.6×CI-1 1×CA-2** | 10 | 11 | 19 | 754 |
| **Comp. 21 4.6×CI-1 4×CA-2** | 11 | 15 | 32 | 882 |

### Example 4

In this example, a patterned coupon of copper with a cobalt liner was soaked in each of Polishing Compositions 22-24 at 60°C for five minutes. Compositions 22-24 contained the same ingredients (i.e., all of the components shown in Table 1) at the same concentrations except for the differences identified below and in Table 5. After the soaking, the resultant slurry was analyzed with ICP-MS to determine the concentration of cobalt ions etched from the patterned coupon.

Table 5 below demonstrates that the cobalt ion concentration in the polishing slurry decreased with the addition of the Co CI, indicating the protective capabilities of the Co CI during polishing. *See* the column under "60°C SER Co ions Conc.". Table 5 also shows electrochemical testing data obtained from testing blanket coupons of Cu or Co, where the corrosion potential (Ecorr) and the current corresponding to the corrosion potential (Icorr) for cobalt and copper are compared when measured in a polishing slurry containing all of the components shown in Table 1 (except that Composition 22 did not include a cobalt corrosion inhibitor). In general, a higher value for Ecorr or a lower value for Icorr indicates that the material in question is better protected/passivated. Thus, it can be seen that Composition 24, which included the highest amount of the Co CI, had the highest protection/passivation for cobalt. Further, the addition of the Co CI is shown to not appreciably affect the corrosion potential of copper.

**Table 5**

| | **60°C SER Co ions Conc. (ppb)** | **Co Ecorr. (mV)** | **Co Icorr. (µA)** | **Cu Ecorr. (mV)** | **Cu Icorr. (µA)** |
|---|---|---|---|---|---|
| **Comp. 22 w/o Co CI** | 12.6 | 185.86 | 4.48 | 153.04 | 0.012 |
| **Comp. 23 w/ 0.5**× **Co CI** | 10.1 | 202.47 | 3.09 | 150.22 | 0.012 |
| **Comp. 24 w/ 1× Co CI** | 9.0 | 222.31 | 1.52 | 154.35 | 0.008 |

### Example 5

Table 6 below shows the removal rate for Cu, TEOS, TaN, Black Diamond 1 (BD-1), and an ultra low-k (ULK) blanket wafers when polished using Compositions 25-29. Compositions 25-29 contained the same ingredients at the same concentrations except for the differences identified below and in Table 4. Specifically, Composition 25 included no low-k removal rate inhibitor, Composition 26 included a single polyalkoxylate low-k removal rate inhibitor (LK RRI), Compositions 27 and 28 included only one of LK RRI-1 or LK RRI-2, and Composition 29 included a combination of two distinct LK RRI's (i.e., an alkoxylated diamine non-ionic surfactant (LK RRI-1) and an amphiphilic copolymer (LK RRI-2)).

The results showed surprisingly that the nonionic surfactant (LK RRI and LK RRI-1) and the amphiphilic copolymer (LK RRI-2) could be used as low-k removal rate inhibitors, and that the combination of both LK RRI-1 and LK RRI-2 suppressed the polishing rates of BD-1 more effectively than the comparative LK RRI or each of LK RRI-1 and LK RRI-2 used singly.

**Table 6**

| | **Comp. 25 w/o LK RRI** | **Comp. 26 1**× **LK RRI** | **Comp. 27 1**× **LK RRI-1** | **Comp. 28 1**× **LK RRI-2** | **Comp. 29 1**× **(LK RRI-1** + **LK RRI-2)** |
|---|---|---|---|---|---|
| **Cu (Å/min)** | 178 | 158 | 183 | 187 | 147 |
| **TEOS (Å/min)** | 126 | 105 | 109 | 106 | 119 |
| **TaN (Å/min)** | 234 | 238 | 166 | 225 | 248 |
| **BD-1 (Å/min)** | 1358 | 53 | 22 | 30 | 18 |
| **ULK (Å/min)** | 1828 | 459 | 427 | 352 | 246 |

## Claims

1. A polishing composition, comprising:
an abrasive;
a pH adjuster;
a barrier film removal rate enhancer;
a first low-k removal rate inhibitor;
a second low-k removal rate inhibitor different from the first low-k removal rate inhibitor;
an azole-containing corrosion inhibitor; and
a cobalt corrosion inhibitor.

2. The polishing composition of claim 1, wherein the abrasive is selected from the group consisting of alumina, silica, titania, ceria, zirconia, co-formed products of alumina, silica, titania, ceria, or zirconia, coated abrasives, surface modified abrasives, and mixtures thereof.

3. The polishing composition of claim 1 or claim 2, wherein the abrasive is in an amount of from 0.1% to 50% by weight of the composition.

4. The polishing composition of any one of claims 1-3, wherein the barrier film removal rate enhancer is an organic acid or a salt thereof selected from the group consisting of gluconic acid, lactic acid, citric acid, tartaric acid, malic acid, glycolic acid, malonic acid, formic acid, oxalic acid, acetic acid, propionic acid, peracetic acid, succinic acid, lactic acid, potassium acetate, potassium citrate, amino acetic acid, phenoxyacetic acid, bicine, diglycolic acid, glyceric acid, tricine, alanine, histidine, valine, phenylalanine, proline, glutamine, aspartic acid, glutamic acid, arginine, lysine, tyrosine, benzoic acid, 1,2-ethanedisulfonic acid, 4-amino-3-hydroxy-1-naphthalenesulfonic acid, 8-hydroxyquinoline-5-sulfonic acid, aminomethanesulfonic acid, benzenesulfonic acid, hydroxylamine O-sulfonic acid, methanesulfonic Acid, m-xylene-4-sulfonic acid, poly(4-styrenesulfonic acid), polyanetholesulfonic acid, p-toluenesulfonic acid, trifluoromethane-sulfonic acid, ethyl phosphoric acid, cyanoethyl phosphoric acid, phenyl phosphoric acid, vinyl phosphoric acid, poly(vinylphosphonic acid), 1-hydroxyethane-1,1-diphosphonic acid, nitrilotri(methylphosphonic acid), diethylenetriaminepentakis (methylphosphonic acid), N,N,N'N'-ethylenediaminetetrakis(methylene phosphonic acid), n-hexylphosphonic acid, benzylphosphonic acid, phenylphosphonic acid, salts thereof, and mixtures thereof.

5. The polishing composition of any one of claims 1-4, wherein the barrier film removal rate enhancer is in an amount of from 0.02% to 4% by weight of the composition.

6. The polishing composition of any one of claims 1-5, wherein the first low-k removal rate inhibitor is a nonionic surfactant, optionally wherein the nonionic surfactant is selected from the group consisting of alcohol alkoxylates, alkylphenol alkoxylates, tristyrylphenol alkoxylates, sorbitan ester alkoxylates, polyalkoxylates, polyalkylene oxide block copolymers, tetrahydroxy oligomers, an alkoxylated diamine, and mixtures thereof.

7. The polishing composition of any one of claims 1-6, wherein the first low-k removal rate inhibitor is in an amount of from 0.005% to 5% by weight of the composition.

8. The polishing composition of any one of claims 1-7, wherein the second low-k removal rate inhibitor is an amphiphilic copolymer, optionally wherein the amphiphilic copolymer is a styrene maleic anhydride copolymer.

9. The polishing composition of any one of claims 1-8, wherein the second low-k removal rate inhibitor is in an amount of from 0.005% to 5% by weight of the composition.

10. The polishing composition of any one of claims 1-9, wherein the azole-containing corrosion inhibitor is selected from the group consisting of triazole, tetrazole, benzotriazole, tolyltriazole, ethyl benzotriazole, propyl benzotriazole, butyl benzotriazole, pentyl benzotriazole, hexyl benzotriazole, dimethyl benzotriazole, chloro benzotriazole, dichloro benzotriazole, chloromethyl benzotriazole, chloroethyl benzotriazole, phenyl benzotriazole, benzyl benzotriazole, aminotriazole, aminobenzimidazole, pyrazole, imidazole, aminotetrazole, and mixtures thereof, and/or wherein the azole-containing corrosion inhibitor is in an amount of from 0.0001% to 1% by weight of the composition.

11. The polishing composition of any one of claims 1-10, wherein the cobalt corrosion inhibitor is an anionic surfactant, optionally wherein the anionic surfactant comprises one or more phosphate groups and one or more of the following: a six to twenty four carbon alkyl chain, zero to eighteen ethylene oxide groups, or a combination thereof, and/or wherein the cobalt corrosion inhibitor is in an amount of from 0.0001% to 1% by weight of the composition.

12. The polishing composition of any one of claims 1-11, wherein the pH adjustor is selected from the group consisting of ammonium hydroxide, sodium hydroxide, potassium hydroxide, cesium hydroxide, monoethanolamine, diethanolamine, triethanolamine, methylethanolamine, methyldiethanolamine tetrabutylammonium hydroxide, tetrapropylammonium hydroxide, tetraethylammonium hydroxide, tetramethylammonium hydroxide, ethyltrimethylammonium hydroxide, diethyldimethylammonium hydroxide, dimethyldipropylammonium hydroxide, benzyltrimethylammonium hydroxide, tris(2-hydroxyethyl)methylammonium hydroxide, choline hydroxide, and any combinations thereof, and/or wherein the pH adjustor is in an amount of from 0.05% to 10% by weight of the composition,
optionally wherein the pH of the composition is between 7 and 14.

13. The polishing composition of any one of claims 1-12, further comprising: a chelating agent selected from the group consisting of ethylenediaminetetracetic acid, iminodiacetic acid, N-hydroxyethyl-ethylenediaminetriacetic acid, nitrilotriacetic acid, diethylenetriaminepentacetic acid, hydroxyethylethylenediaminetriacetic acid, triethylenetetraaminehexaacetic acid, diaminocycloheanetetraacetic acid, nitrilotrimethylphosphonic acid, ethylenediaminetetra(methylenephosphonic acid), 1-hydroxyl ethylidene-1,1,-diphosphonic acid, diethylenetriamine penta (methylene phosphonic acid), and combinations thereof, and/or wherein the chelating agent is in an amount of from 0.001% to 1% by weight of the composition.

14. The polishing composition of claim 1, wherein the composition comprises:
the abrasive in an amount of from 0.1% to 50% by weight of the composition;
the pH adjuster in an amount of from 0.05% to 10% by weight of the composition;
the barrier film removal rate enhancer in an amount of from 0.02% to 4% by weight of the composition;
the first low-k removal rate inhibitor in an amount of from 0.005% to 5% by weight of the composition;
the second low-k removal rate inhibitor in an amount of from 0.005% to 5% by weight of the composition;
the azole-containing corrosion inhibitor in an amount of from 0.0001% to 1% by weight of the composition; and
the cobalt corrosion inhibitor in an amount of from 0.0001% to 1% by weight of the composition.

15. A method of polishing a substrate, comprising the steps of:
applying the polishing composition of any one of claims 1-14 to a surface of a substrate, wherein the surface comprises cobalt; and
bringing a pad into contact with the surface of the substrate and moving the pad in relation to the substrate.

## Patentansprüche

1. Polierzusammensetzung, umfassend:
einen Abrasivstoff;
ein pH-Einstellmittel;
einen Sperrschichtentfernungsratenverstärker;
einen ersten Low-k-Entfernungsratenhemmer;
einen zweiten Low-k-Entfernungsratenhemmer, der von dem ersten Low-k-Entfernungsratenhemmer verschieden ist;
einen azolhaltigen Korrosionshemmer; und
einen Cobaltkorrosionshemmer.

2. Polierzusammensetzung gemäß Anspruch 1, wobei der Abrasivstoff ausgewählt ist aus der Gruppe bestehend aus Aluminiumoxid, Siliciumdioxid, Titandioxid, Cerdioxid, Zirkondioxid, mitgebildeten Produkten von Aluminiumoxid, Siliciumdioxid, Titandioxid, Cerdioxid oder Zirkondioxid, beschichteten Abrasivstoffen, oberflächenmodifizierten Abrasivstoffen und Gemischen davon.

3. Polierzusammensetzung gemäß Anspruch 1 oder Anspruch 2, wobei der Abrasivstoff in einer Menge von 0,1 Gew.-% bis 50 Gew.-% der Zusammensetzung vorliegt.

4. Polierzusammensetzung gemäß einem der Ansprüche 1-3, wobei der Sperrschichtentfernungsratenverstärker eine organische Säure oder ein Salz davon ausgewählt aus der Gruppe bestehend aus Gluconsäure, Milchsäure, Citronensäure, Weinsäure, Apfelsäure, Glycolsäure, Malonsäure, Ameisensäure, Oxalsäure, Essigsäure, Propionsäure, Peressigsäure, Bernsteinsäure, Milchsäure, Kaliumacetat, Kaliumcitrat, Aminoessigsäure, Phenoxyessigsäure, Bicin, Diglycolsäure, Glycerinsäure, Tricin, Alanin, Histidin, Valin, Phenylalanin, Prolin, Glutamin, Asparaginsäure, Glutaminsäure, Arginin, Lysin, Tyrosin, Benzoesäure, 1,2-Ethandisulfonsäure, 4-Amino-3-hydroxy-1-naphthalinsulfonsäure, 8-Hydroxychinolin-5-sulfonsäure, Aminomethansulfonsäure, Benzolsulfonsäure, Hydroxylamin-O-sulfonsäure, Methansulfonsäure, m-Xylen-4-sulfonsäure, Poly(4-styrolsulfonsäure), Polyanetholsulfonsäure, p-Toluolsulfonsäure, Trifluormethansulfonsäure, Ethylphosphorsäure, Cyanoethylphosphorsäure, Phenylphosphorsäure, Vinylphosphorsäure, Poly(vinylphosphonsäure), 1-Hydroxyethan-1,1-diphosphonsäure, Nitrilotri(methylphosphonsäure), Diethylentriaminpentakis(methylphosphonsäure), N,N,N'N'-Ethylendiamintetrakis(methylenphosphonsäure), n-Hexylphosphonsäure, Benzylphosphonsäure, Phenylphosphonsäure, Salzen davon und Gemischen davon ist.

5. Polierzusammensetzung gemäß einem der Ansprüche 1-4, wobei der Sperrschichtentfernungsratenverstärker in einer Menge von 0,02 Gew.-% bis 4 Gew.-% der Zusammensetzung vorliegt.

6. Polierzusammensetzung gemäß einem der Ansprüche 1-5, wobei der erste Low-k-Entfernungsratenhemmer ein nichtionisches Tensid ist, gegebenenfalls wobei das nichtionische Tensid ausgewählt ist aus der Gruppe bestehend aus Alkoholalkoxylaten, Alkylphenolalkoxylaten, Tristyrylphenolalkoxylaten, Sorbitanesteralkoxylaten, Polyalkoxylaten, Polyalkylenoxid-Blockcopolymeren, Tetrahydroxyoligomeren, einem alkoxylierten Diamin und Gemischen davon.

7. Polierzusammensetzung gemäß einem der Ansprüche 1-6, wobei der erste Low-k-Entfernungsratenhemmer in einer Menge von 0,005 Gew.-% bis 5 Gew.-% der Zusammensetzung vorliegt.

8. Polierzusammensetzung gemäß einem der Ansprüche 1-7, wobei der zweite Low-k-Entfernungsratenhemmer ein amphiphilies Copolymer ist, gegebenenfalls wobei das amphiphile Copolymer ein Styrol-Maleinsäureanhydrid-Copolymer ist.

9. Polierzusammensetzung gemäß einem der Ansprüche 1-8, wobei der zweite Low-k-Entfernungsratenhemmer in einer Menge von 0,005 Gew.-% bis 5 Gew.-% der Zusammensetzung vorliegt.

10. Polierzusammensetzung gemäß einem der Ansprüche 1-9, wobei der azolhaltige Korrosionshemmer ausgewählt ist aus der Gruppe bestehend aus Triazol, Tetrazol, Benzotriazol, Tolyltriazol, Ethylbenzotriazol, Propylbenzotriazol, Butylbenzotriazol, Pentylbenzotriazol, Hexylbenzotriazol, Dimethylbenzotriazol, Chlorbenzotriazol, Dichlorbenzotriazol, Chlormethylbenzotriazol, Chlorethylbenzotriazol, Phenylbenzotriazol, Benzylbenzotriazol, Aminotriazol, Aminobenzimidazol, Pyrazol, Imidazol, Aminotetrazol und Gemischen davon und/oder wobei der azolhaltige Korrosionshemmer in einer Menge von 0,0001 Gew.-% bis 1 Gew.-% der Zusammensetzung vorliegt.

11. Polierzusammensetzung gemäß einem der Ansprüche 1-10, wobei der Cobaltkorrosionshemmer ein anionisches Tensid ist, gegebenenfalls wobei das anionische Tensid eine oder mehrere Phosphatgruppen und eines oder mehrere der Folgenden umfasst: eine Alkylkette mit sechs bis vierundzwanzig Kohlenstoffatomen, null bis achtzehn Ethylenoxidgruppen oder eine Kombination davon, und/oder wobei der Cobaltkorrosionshemmer in einer Menge von 0,0001 Gew.-% bis 1 Gew.-% der Zusammensetzung vorliegt.

12. Polierzusammensetzung gemäß einem der Ansprüche 1-11, wobei das pH-Einstellmittel ausgewählt ist aus der Gruppe bestehend aus Ammoniumhydroxid, Natriumydroxid, Kaliumhydroxid, Cäsiumhydroxid, Monoethanolamin, Diethanolamin, Triethanolamin, Methylethanolamin, Methyldiethanolamin, Tetrabutylammoniumhydroxid, Tetrapropylammoniumhydroxid, Tetraethylammoniumhydroxid, Tetramethylammoniumhydroxid, Ethyltrimethylammoniumhydroxid, Diethyldimethylammoniumhydroxid, Dimethyldipropylammoniumhydroxid, Benzyltrimethylammoniumhydroxid, Tris(2-hydroxyethyl)methylammoniumhydroxid, Cholinhydroxid und beliebigen Kombinationen davon und/oder wobei das pH-Einstellmittel in einer Menge von 0,05 Gew.-% bis 10 Gew.-% der Zusammensetzung vorliegt,
gegebenenfalls wobei der pH-Wert der Zusammensetzung zwischen 7 und 14 liegt.

13. Polierzusammensetzung gemäß einem der Ansprüche 1-12, ferner umfassend:
einen Chelatbildner ausgewählt aus der Gruppe bestehend aus Ethylendiamintetraessigsäure, Iminodiessigsäure, N-Hydroxyethylethylendiamintriessigsäure, Nitrilotriessigsäure, Diethylentriaminpentessigsäure, Hydroxyethylethylendiamintriessigsäure, Triethylentetraminhexaessigsäure, Diaminocyclohexantetraessigsäure, Nitrilotrimethylphosphonsäure, Ethylendiamintetra(methylenphosphonsäure), 1-Hydroxyethyliden-1,1,-diphosphonsäure, Diethylentriaminpenta(methylenphosphonsäure) und Kombinationen davon und/oder wobei der Chelatbildner in einer Menge von 0,001 Gew.-% bis 1 Gew.-% der Zusammensetzung vorliegt.

14. Polierzusammensetzung gemäß Anspruch 1, wobei die Zusammensetzung umfasst:
den Abrasivstoff in einer Menge von 0,1 Gew.-% bis 50 Gew.-% der Zusammensetzung;
das pH-Einstellmittel in einer Menge von 0,05 Gew.-% bis 10 Gew.-% der Zusammensetzung;
den Sperrschichtentfernungsratenverstärker in einer Menge von 0,02 Gew.-% bis 4 Gew.-% der Zusammensetzung;
den ersten Low-k-Entfernungsratenhemmer in einer Menge von 0,005 Gew.-% bis 5 Gew.-% der Zusammensetzung;
den zweiten Low-k-Entfernungsratenhemmer in einer Menge von 0,005 Gew.-% bis 5 Gew.-% der Zusammensetzung;
den azolhaltigen Korrosionshemmer in einer Menge von 0,0001 Gew.-% bis 1 Gew.-% der Zusammensetzung; und
den Cobaltkorrosionshemmer in einer Menge von 0,0001 Gew.-% bis 1 Gew.-% der Zusammensetzung.

15. Verfahren zum Polieren eines Substrats, umfassend die Schritte:
Aufbringen der Polierzusammensetzung gemäß einem der Ansprüche 1-14 auf eine Oberfläche eines Substrats, wobei die Oberfläche Cobalt umfasst; und
Inkontaktbringen eines Kissens mit der Oberfläche des Substrats und Bewegen des Kissens relativ zu dem Substrat.

## Revendications

1. Composition de polissage, comprenant :
un abrasif ;
un agent d'ajustement du pH ;
un agent d'augmentation de la vitesse d'élimination d'un film barrière ;
un premier inhibiteur de vitesse d'élimination de faible k ;
un deuxième inhibiteur de vitesse d'élimination de faible k différent du premier inhibiteur de vitesse d'élimination de faible k ;
un inhibiteur de corrosion contenant un azole ; et
un inhibiteur de corrosion de cobalt.

2. Composition de polissage selon la revendication 1, l'abrasif étant choisi dans le groupe constitué par une alumine, une silice, un oxyde de titane, un oxyde de cérium, une zircone, des produits co-formés d'alumine, de silice, d'oxyde de titane, d'oxyde de cérium ou de zircone, des abrasifs revêtus, des abrasifs modifiés en surface et des mélanges correspondants.

3. Composition de polissage selon la revendication 1 ou la revendication 2, l'abrasif étant présent en une quantité allant de 0,1 % à 50 % en poids de la composition.

4. Composition de polissage selon l'une quelconque des revendications 1 à 3, l'agent d'augmentation de la vitesse d'élimination d'un film barrière étant un acide organique ou un sel correspondant choisi dans le groupe constitué par l'acide gluconique, l'acide lactique, l'acide citrique, l'acide tartrique, l'acide malique, l'acide glycolique, l'acide malonique, l'acide formique, l'acide oxalique, l'acide acétique, l'acide propionique, l'acide peracétique, l'acide succinique, l'acide lactique, l'acétate de potassium, le citrate de potassium, un acide aminoacétique, l'acide phénoxyacétique, la bicine, l'acide diglycolique, l'acide glycérique, la tricine, l'alanine, l'histidine, la valine, la phénylalanine, la proline, la glutamine, l'acide aspartique, l'acide glutamique, l'arginine, la lysine, la tyrosine, l'acide benzoïque, l'acide 1,2-éthanedisulfonique, l'acide 4-amino-3-hydroxy-1-naphtalènesulfonique, l'acide 8-hydroxyquinoline-5-sulfonique, l'acide aminométhanesulfonique, l'acide benzènesulfonique, l'acide hydroxylamine-O-sulfonique, l'acide méthanesulfonique, l'acide m-xylène-4-sulfonique, un poly(acide 4-styrène-sulfonique),un poly(acide anétholsulfonique), l'acide p-toluènesulfonique, l'acide trifluorométhane-sulfonique, l'acide éthylphosphorique, l'acide cyanoéthylphosphorique, l'acide phénylphosphorique, l'acide vinylphosphorique, un poly(acide vinylphosphonique), l'acide 1-hydroxyéthane-1,1-diphosphonique, l'acide nitrilotri(méthylphosphonique), l'acide diéthylènetriaminepentakis(méthylphosphonique), l'acide N,N,N'N'-éthylènediaminetetrakis(méthylènephosphonique), l'acide n-hexylphosphonique, l'acide benzylphosphonique, l'acide phénylphosphonique, des sels correspondants et des mélanges correspondants.

5. Composition de polissage selon l'une quelconque des revendications 1 à 4, l'agent d'augmentation de la vitesse d'élimination d'un film barrière étant présent en une quantité allant de 0,02 % à 4 % en poids de la composition.

6. Composition de polissage selon l'une quelconque des revendications 1 à 5, le premier inhibiteur de vitesse d'élimination de faible k étant un tensioactif non ionique, éventuellement, le tensioactif non ionique étant choisi dans le groupe constitué par des alcoxylates d'alcool, des alcoxylates d'alkylphénol, des alcoxylates de tristyrylphénol, des alcoxylates d'ester de sorbitane, des polyalcoxylates, des copolymères à bloc de poly(oxyde d'alkylène), des oligomères tétrahydroxy, une diamine alcoxylée et des mélanges correspondants.

7. Composition de polissage selon l'une quelconque des revendications 1 à 6, le premier inhibiteur de vitesse d'élimination de faible k étant présent en une quantité allant de 0,005 % à 5 % en poids de la composition.

8. Composition de polissage selon l'une quelconque des revendications 1 à 7, le deuxième inhibiteur de vitesse d'élimination de faible k étant un copolymère amphiphile, éventuellement, le copolymère amphiphile étant un copolymère de styrène et d'anhydride maléique.

9. Composition de polissage selon l'une quelconque des revendications 1 à 8, le deuxième inhibiteur de vitesse d'élimination de faible k étant présent en une quantité allant de 0,005 % à 5 % en poids de la composition.

10. Composition de polissage selon l'une quelconque des revendications 1 à 9, l'inhibiteur de corrosion contenant un azole étant choisi dans le groupe constitué par le triazole, le tétrazole, le benzotriazole, le tolyltriazole, l'éthylbenzotriazole, le propylbenzotriazole, le butylbenzotriazole, le pentylbenzotriazole, l'hexylbenzotriazole, le diméthylbenzotriazole, le chlorobenzotriazole, le dichlorobenzotriazole, le chlorométhylbenzotriazole, le chloroéthylbenzotriazole, le phénylbenzotriazole, le benzylbenzotriazole, l'aminotriazole, l'aminobenzimidazole, le pyrazole, l'imidazole, l'aminotétrazole et des mélanges correspondants et/ou l'inhibiteur de corrosion contenant un azole étant présent en une quantité allant de 0,0001 % à 1 % en poids de la composition.

11. Composition de polissage selon l'une quelconque des revendications 1 à 10, l'inhibiteur de corrosion de cobalt étant un tensioactif anionique, éventuellement le tensioactif anionique comprenant un ou plusieurs groupes phosphate et l'un ou plusieurs parmi les suivants, une chaîne alkyle à six à vingt-quatre carbones, zéro à dix-huit groupes oxyde d'éthylène ou une combinaison correspondante et/ou l'inhibiteur de corrosion de cobalt étant présent en une quantité allant de 0,0001 % à 1 % en poids de la composition.

12. Composition de polissage selon l'une quelconque des revendications 1 à 11, l'agent d'ajustement du pH étant choisi dans le groupe constitué par l'hydroxyde d'ammonium, l'hydroxyde de sodium, l'hydroxyde de potassium, l'hydroxyde de césium, la monoéthanolamine, la diéthanolamine, la triéthanolamine, la méthyléthanolamine, la méthyldiéthanolamine, l'hydroxyde de tétrabutylammonium, l'hydroxyde de tétrapropylammonium, l'hydroxyde de tétraéthylammonium, l'hydroxyde de tétraméthylammonium, l'hydroxyde d'éthyltriméthylammonium, l'hydroxyde de diéthyldiméthylammonium, l'hydroxyde de diméthyldipropylammonium, l'hydroxyde de benzyltriméthylammonium, l'hydroxyde de tris(2-hydroxyéthyl)méthylammonium, l'hydroxyde de choline et de quelconques combinaisons correspondantes et/ou l'agent d'ajustement du pH étant présent en une quantité allant de 0,05 % à 10 % en poids de la composition, éventuellement le pH de la composition étant compris entre 7 et 14.

13. Composition de polissage selon l'une quelconque des revendications 1 à 12, comprenant en outre :
un agent chélatant choisi dans le groupe constitué par l'acide éthylènediaminetétracétique, l'acide iminodiacétique, l'acide N-hydroxyéthyléthylènediaminetriacétique, l'acide nitrilotriacétique, l'acide diéthylènediphénylpentacétique, l'acide hydroxyéthyléthylènediaminetriacétique, l'acide triéthylènetétraaminehexaacétique, l'acide diaminocyclohexanetétraacétique, l'acide nitrilotriméthylphosphonique, l'acide éthylènediaminetétra(méthylènephosphonique), l'acide 1-hydroxyléthylidène-1,1,-diphosphonique, l'acide diéthylènetriaminepenta(méthylène phosphonique) et des combinaisons correspondantes et/ou l'agent chélatant étant présent en une quantité allant de 0,001 % à 1 % en poids de la composition.

14. Composition de polissage selon la revendication 1, la composition comprenant :
l'abrasif en une quantité allant de 0,1 % à 50 % en poids de la composition ;
l'agent d'ajustement du pH en une quantité allant de 0,05 % à 10 % en poids de la composition ;
l'agent d'augmentation de la vitesse d'élimination d'un film barrière en une quantité allant de 0,02 % à 4 % en poids de la composition ;
le premier inhibiteur de la vitesse d'élimination de faible k en une quantité allant de 0,005 % à 5 % en poids de la composition ;
le deuxième inhibiteur de la vitesse d'élimination de faible k en une quantité allant de 0,005 % à 5 % en poids de la composition ;
l'inhibiteur de corrosion contenant un azole en une quantité allant de 0,0001 % à 1 % en poids de la composition ; et
l'inhibiteur de corrosion de cobalt en une quantité allant de 0,0001 % à 1 % en poids de la composition.

15. Procédé de polissage d'un substrat, comprenant les étapes de :
application de la composition de polissage selon l'une quelconque des revendications 1 à 14 sur une surface d'un substrat, la surface comprenant du cobalt ; et
mise en contact d'un tampon avec la surface du substrat et déplacement du tampon par rapport au substrat.
